# EUROPEAN PATENT APPLICATION

(11) **EP 4 651 670 A1**
(43) Date of publication of application: **19.11.2025**
(21) Application number: 24892473.0
(22) Date of filing: 20.09.2024
(51) Int. Cl.: H10D 30/60, H10D 64/27, H10D 62/17

(54) **METAL-OXIDE-SEMICONDUCTOR FIELD-EFFECT TRANSISTOR (MOSFET) AND MANUFACTURING METHOD THEREFOR**

(30) Priority: 20.03.2024 CN 202410319696
(71) Applicant: Zhuzhou CRRC Times Semiconductor Co., Ltd., Zhuzhou, Hunan 412005 (CN)
(72) Inventor: SONG, Guan, Zhuzhou, Hunan 412005 (CN); WANG, Yafei, Zhuzhou, Hunan 412005 (CN); LIU, Qijun, Zhuzhou, Hunan 412005 (CN); ZHANG, Wenjie, Zhuzhou, Hunan 412005 (CN); YUAN, Xin, Zhuzhou, Hunan 412005 (CN); YAO, Yao, Zhuzhou, Hunan 412005 (CN); LI, Chengzhan, Zhuzhou, Hunan 412005 (CN); LUO, Haihui, Zhuzhou, Hunan 412005 (CN)
(74) Representative: Petraz, Gilberto Luigi
(86) International application number: PCT/CN2024/119952
(87) International publication number: WO 2025/194722

(57) **Abstract**

The present disclosure proposes a MOSFET and manufacturing method thereof. The MOSFET includes a substrate; an epitaxial layer, disposed on the substrate; a trench gate group, including a first trench gate and a plurality of second trench gates, wherein the first trench gate extends into the epitaxial layer from a surface of the epitaxial layer on a side thereof away from the substrate, and the first trench gate extends along a first direction in a plane where the epitaxial layer is located, the plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate; and a plurality of shielding regions, each of which wraps around a bottom and all the sidewalls of the second trench gate, and extends towards a surface of the epitaxial layer on a side thereof away from the substrate to cover sidewalls of the first trench gate, and the plurality of shielding regions are arranged at intervals. The shielding region has a three-dimensional structure, such that not only an electric field stress of the trench gate oxide may be reduced, but also the cell size of the MOSFET may be reduced, thereby improving the current density of the MOSFET.

## Description

The present application claims the priority of Chinese patent application No. CN202410319696.8 entitled "Metal oxide semiconductor field-effect transistor and manufacturing method thereof" and filed on March 20, 2024, the entire content of which is incorporated herein by reference.

### Technical Field

The present disclosure relates to the field of semiconductor device technology, specifically to a metal oxide semiconductor field-effect transistor and manufacturing method thereof.

### Background

With the development of power semiconductor technology, a silicon carbide metal oxide semiconductor field-effect transistor (MOSFET), due to its material advantage, has become increasingly common for applications in the fields of new energy, wind power, photovoltaics, and energy storage.

Among others, a trench gate MOSFET can reduce cell size and significantly increase a current density of the MOSFET as compared to a planar gate MOSFET. However, due to the characteristic of wide bandgap of the silicon carbide material, a gate oxide in a trench has an extremely high electric field stress. Therefore, it is necessary to design an electric field shielding structure to protect the gate oxide in the trench to meet long-term reliability requirements. However, the electric field shielding structure will introduce parasitic junction field-effect transistor (JFET) regional resistance, resulting in a decrease of the current density of the MOSFET. At present, the current density of the trench gate silicon carbide MOSFET with the shielding structure needs to be increased, and the cell size thereof needs to be further reduced.

### Summary

The present disclosure aims at least partially solving one of the technical problems in the related art.

Therefore, in an aspect of the present disclosure, a metal oxide semiconductor field-effect transistor is proposed. The metal oxide semiconductor field-effect transistor includes: a substrate; an epitaxial layer, disposed on the substrate; a trench gate group, including a first trench gate and a plurality of second trench gates, wherein the first trench gate extends into the epitaxial layer from a surface of the epitaxial layer on a side thereof away from the substrate, and the first trench gate extends along a first direction in a plane where the epitaxial layer is located, the plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate; and a plurality of shielding regions, each of which wraps around a bottom and all the sidewalls of the second trench gate, and extends towards a surface of the epitaxial layer on a side thereof away from the substrate to cover sidewalls of the first trench gate, and the plurality of shielding regions are arranged at intervals. The shielding region is formed as a three-dimensional structure, such that not only an electric field stress of the trench gate oxide may be reduced, but also the cell size of the MOSFET may be reduced, thereby improving the current density of the MOSFET.

Further, the second trench gate extends into the substrate in a direction of stacking the substrate and the epitaxial layer; or, a buffer layer is disposed between the substrate and the epitaxial layer, and the second trench gate extends into the buffer layer or into the substrate in the direction of stacking the substrate and the epitaxial layer.

Further, the second trench gate may include a plurality of trench gate portions that are connected with each other, and the plurality of trench gate portions may be sequentially arranged in a direction in which the epitaxial layer faces the substrate, with their widths decreasing in sequence.

Further, a thickness of a portion of the shielding region covering the sidewalls of the first trench gate may be consistent with a thickness of a portion of the shielding region wrapping around the sidewalls of the second trench gate, and the thickness may be 0.1 µm-1 µm, and a thickness of a portion of the shielding region wrapping around the bottom of the second trench gate may be 0.5 µm-2 µm.

Further, the shielding region may have a doping concentration of 1 × 10¹⁶ cm⁻³-1 × 10¹⁹ cm⁻³.

Further, a plurality of trench gate groups may be included, wherein first trench gates in the plurality of trench gate groups may be sequentially arranged along a second direction in the plane where the epitaxial layer is located, the second direction may intersect with the first direction, and two adjacent second trench gates may be arranged in a same row or in a staggered row in the second direction.

Further, the metal oxide semiconductor field-effect transistor may include a plurality of trench gate groups, wherein first trench gates in the plurality of trench gate groups may be sequentially arranged along a second direction in the plane where the epitaxial layer is located, and the second direction may intersect with the first direction; N+ regions and P+ regions in the epitaxial layer may extend into the epitaxial layer from the surface of the epitaxial layer on a side thereof away from the substrate, a top of a P well region in the epitaxial layer may be in contact with a bottom of the N+ region and a bottom of the P+ region, and the first trench gate may penetrate through the N+ region and the P well region; the P+ regions may be arranged at intervals along the first direction and each may be located between two adjacent first trench gates, and the N+ region may be located around the P+ region, or, the P+ regions may extend along the first direction and each may be located between two adjacent first trench gates, and the N+ region may be located on two sides of the P+ region.

Further, the metal oxide semiconductor field-effect transistor may include: a plurality of trench gate groups, wherein first trench gates in the plurality of trench gate groups may be sequentially arranged along a second direction in the plane where the epitaxial layer is located, and the second direction may intersect with the first direction; and a plurality of third trench gates extending along the second direction and sequentially arranged along the first direction, the third trench gates extending into the epitaxial layer from the surface of the epitaxial layer on a side thereof away from the substrate. The orthographic projection of the second trench gate on the substrate may be located within an orthographic projection range of an intersection region of the first trench gate and the third trench gate on the substrate, and each shielding region further may cover sidewalls of the third trench gate, or, the orthographic projection of the second trench gate on the substrate may be located between orthographic projections of two adjacent third trench gates on the substrate, and each shielding region may be located between the two adjacent third trench gates.

Further, N+ regions and the P+ regions in the epitaxial layer may extend into the epitaxial layer from a surface of the epitaxial layer on a side thereof away from the substrate, a top of a P well region in the epitaxial layer may be in contact with a bottom of the N+ region and a bottom of the P+ region, both of the first trench gate and the third trench gate may penetrate the N+ region and the P well region, the P+ region may be located in a region surrounded by the first trench gate and the third trench gate, and the N+ region may be located around the P+ region.

Further, the third trench gates and the first trench gates may define multiple cells, and the cell may have a square, hexagonal, octagonal, or circular shape.

In another aspect of the present disclosure, a method for manufacturing a metal oxide semiconductor field-effect transistor is proposed, the method including: forming an epitaxial layer on a substrate; and forming a trench gate group and a plurality of shielding regions in the epitaxial layer, wherein the trench gate group includes a first trench gate and a plurality of second trench gates, the first trench gate extends into the epitaxial layer from a surface of the epitaxial layer on a side thereof away from the substrate, and the first trench gate extends along a first direction in a plane where the epitaxial layer is located, the plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate, each shielding region wraps around a bottom and all the sidewalls of the second trench gate, and extends towards a surface of the epitaxial layer on a side thereof away from the substrate to cover sidewalls of the first trench gate, and the plurality of shielding regions are arranged at intervals. The shielding region formed by this method has a three-dimensional structure, such that not only an electric field stress of the trench gate oxide may be reduced, but also the cell size of the MOSFET may be reduced, thereby improving the current density of the MOSFET.

Further, forming a trench gate group and a plurality of shielding regions in the epitaxial layer may include: forming a first trench, wherein the first trench may extend into the epitaxial layer from a surface of the epitaxial layer on the side away from the substrate, and the first trench may extend along the first direction; forming a plurality of second trenches in the first trench, wherein the plurality of second trenches may be arranged at intervals along the first direction; forming a plurality of shielding regions, wherein each shielding region may wrap around the bottom and all sidewalls of the second trench, and may extend towards the surface of the epitaxial layer on a side thereof away from the substrate to cover the sidewalls of the first trench; forming a gate oxide layer on the sidewalls and the bottoms of the first trench and the second trench; and forming a gate electrode layer in the first trench and the second trench, wherein the gate electrode layer may be in contact with the gate oxide layer to form the first trench gate and the second trench gate, so as to form the trench gate group.

### Brief Description of the Drawings

In order to more clearly illustrate the technical solutions of the embodiments of the present disclosure, a brief introduction will be made to the accompanying drawings required for the description of the embodiments. It is obvious for those skilled in the art that the accompanying drawings described below are some embodiments of the present disclosure, and other accompanying drawings may be obtained based on these accompanying drawings without creative effort.
Fig. 1 shows a schematic top view of a MOSFET according to an embodiment of the present disclosure;
Fig. 2 shows a schematic view of a structure of the MOSFET taken along line A-A' in Fig. 1;
Fig. 3 shows a schematic view of a structure of the MOSFET taken along line B-B' in Fig. 1;
Fig. 4 shows a schematic view of a structure of the MOSFET taken along line C-C' in Fig. 1;
Fig. 5 shows a schematic view of a structure of the MOSFET taken along line D-D' in Fig. 1;
Fig. 6 shows a schematic view of a structure of a MOSFET according to another embodiment of the present disclosure;
Fig. 7 shows a schematic top view of a MOSFET according to another embodiment of the present disclosure;
Fig. 8 shows a schematic top view of a MOSFET according to another embodiment of the present disclosure;
Fig. 9 shows a schematic top view of a MOSFET according to another embodiment of the present disclosure;
Fig. 10 shows a schematic top view of a MOSFET according to another embodiment of the present disclosure;
Fig. 11 shows a schematic flowchart view of a method for manufacturing MOSFET according to an embodiment of the present disclosure; and
Fig. 12 shows a schematic view of a partial flowchart of a method for manufacturing MOSFET according to an embodiment of the present disclosure.

### Detailed Description of the Embodiments

In the following, the embodiments of the present disclosure will be described in detail. The embodiments described below are exemplary and are only used to explain the present disclosure, but should not be construed to limit the present disclosure. If specific technologies or conditions are not specified in the embodiments, the technologies or conditions described in the literatures in the art or the product specification are followed.

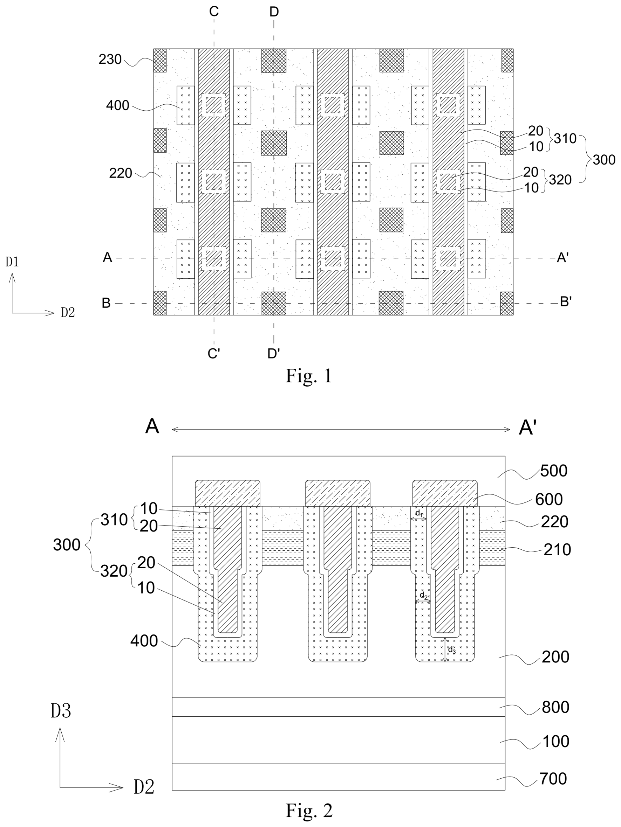

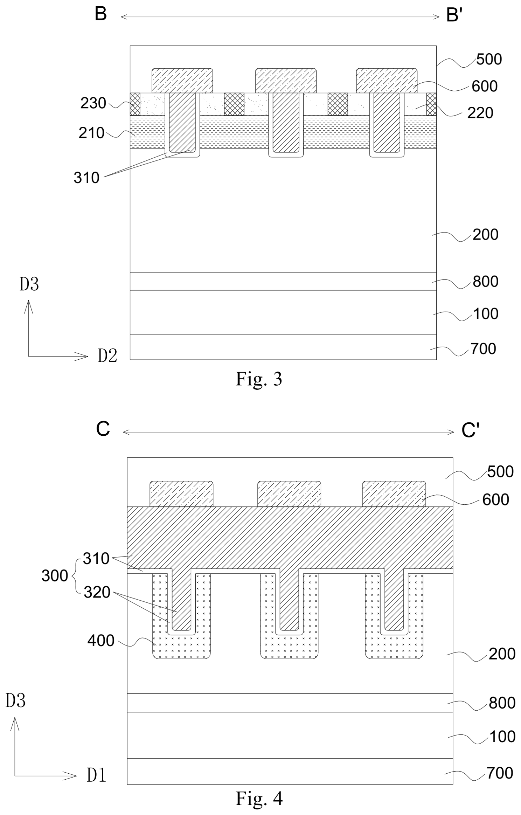

In one aspect of the present disclosure, a metal oxide semiconductor field-effect transistor is proposed. In some embodiments of the present disclosure, referring to Figures 1-5, the metal oxide semiconductor field-effect transistor includes a substrate 100, an epitaxial layer 200, a trench gate group 300, and a plurality of shielding regions 400. The epitaxial layer 200 is disposed on the substrate 100, and the trench gate group 300 includes a first trench gate 310 and a plurality of second trench gates 320. The first trench gate 310 extends into the epitaxial layer 200 from a surface of the epitaxial layer 200 on a side thereof away from the substrate 100 (as shown in Figure 2), and the first trench gate 310 extends along a first direction D1 in a plane where the epitaxial layer 200 is located. The plurality of second trench gates 320 are arranged along at intervals along the first direction D1. An orthographic projection of the second trench gate 320 on the substrate 100 is located within an orthographic projection range of the first trench gate 310 on the substrate 100. A top of the second trench gate 320 is in contact with a bottom of the first trench gate 310, and a gate electrode layer 20 in the second trench gate 320 is connected with a gate electrode layer 20 in the first trench gate 310 (as shown in Figure 2). Each shielding region 400 wraps around a bottom and all sidewalls of the second trench gate 320 (as shown in Figures 2 and 4), and extends towards the surface of the epitaxial layer 200 on a side thereof away from the substrate 100 to cover sidewalls of the first trench gate 310 (as shown in Figure 2). The plurality of shielding regions 400 are arranged at intervals.

Since the second trench gates 320 are arranged along at intervals along the first direction D1, the shielding region 400 may wrap around all the sidewalls of the second trench gate 320. As shown in Figure 2, the shielding region 400 covers the sidewalls of the second trench gate 320 in the second direction D2, and as shown in Figure 4, the shielding region 400 also covers the sidewalls of the second trench gate 320 in the first direction D1. The second direction D2 is a direction intersecting with the first direction D1 on a plane where the epitaxial layer 200 is located, and more specifically, the second direction D2 is perpendicular to the first direction D1.

Each shielding region 400 wraps around the bottom and all the sidewalls of the second trench gate 320, and extends towards the surface of the epitaxial layer 200 on the side thereof away from the substrate 100 to cover the sidewalls of the first trench gate 310 (as shown in Figures 1 and 2). In the present disclosure, the second trench gates are arranged at intervals below the first trench gate, such that the shielding region with a three-dimensional structure is obtained. In a first aspect, the shielding regions can reduce the electric field stress of the gate oxide in the trench gate, thereby improving the long-term reliability of the MOSFET. In a second aspect, compared with the current two-dimensional shielding structures, since the shielding region is formed in a three-dimensional direction (i.e., the first direction D1) in the present disclosure, the size of the MOSFET cell in a two-dimensional direction may be significantly reduced, thereby improving the current density of the MOSFET. In a third aspect, the shielding region around the second trench gate is completely depleted when the MOSFET is in a blocking state, such that a doping concentration of the epitaxial layer may be significantly increased, and the resistance of a JFET region may be reduced, thereby improving the current density of the MOSFET.

The plurality of shielding regions 400 are arranged at intervals. As shown in Figure 1, the shielding regions are arranged at intervals in the first direction to ensure the conductivity of the MOSFET.

It should be noted that, the top of the second trench gate 320 is an end of the second trench gate 320 on a side thereof away from the substrate 100, the bottom of the first trench gate 310 is an end of the first trench gate 310 on a side thereof close to the substrate 100, and the bottom of the second trench gate 320 is an end of the second trench gate 320 on a side thereof close to the substrate 100.

In some embodiments of the present disclosure, referring to Figure 2, the first trench gate 310 includes a gate oxide layer 10 disposed on an inner wall and a bottom of a first trench, and a gate electrode layer 20 filled in the middle of the first trench and in contact with the gate oxide layer 10. The second trench gate 320 includes a gate oxide layer 10 disposed on an inner wall and a bottom of a second trench, and a gate electrode layer 20 filled in the middle of the second trench and in contact with the gate oxide layer 10, and the gate electrode layer 20 of the second trench gate 320 is connected with the gate electrode layer 20 of the first trench gate 310. The first trench is a trench configured to form the first trench gate, and the second trench is a trench configured to form the second trench gate. A material of the gate electrode layer may include polycrystalline silicon, and a thickness of the gate oxide layer 10 may be 300 Å-1000 Å.

The plurality of second trench gates 320 are arranged along at intervals along the first direction D1, and preferably, a distance between arbitrary two adjacent second trench gates 320 is equal, thereby improving the stability of the MOSFET. The specific distance between two adjacent second trench gates is not particularly limited, and those skilled in the art may perform design according to specific conditions. For example, if the epitaxial layer has a high doping concentration, the distance between two adjacent second trench gates may be relatively small.

The second trench gates 320 are arranged along at intervals along the first direction D1, and the orthographic projection of the second trench gate 320 on the substrate 100 is located within the orthographic projection range of the first trench gates 310 on the substrate 100. Thus, in the second direction D2, a width of the second trench gate is equal to or less than that of the first trench gate. The width of the first trench gate may be 0.3 µm-2 µm. The specific width of the second trench gate is not particularly limited, and may be designed according to specific conditions. A length of the second trench gate in the first direction is also not particularly limited. Preferably, the length and the width of the second trench gate may be equal, that is, the orthographic projection of the second trench gate on the substrate is square.

In some embodiments of the present disclosure, a depth of the first trench gate 310 may be 0.4 µm-2 µm. A depth of the second trench gate is not particularly limited. For example, in a direction of stacking the substrate 100 and the epitaxial layer 200, i.e., in a third direction D3, the second trench gate may extend into the substrate 100 (this situation is not shown in the figure). When a buffer layer 800 is disposed between the substrate 100 and the epitaxial layer 200 (as shown in Figure 2), the second trench gate may extend into the buffer layer 800 in the third direction D3, or, the second trench gate penetrates through the buffer layer 800 and extends into the substrate 100 (this situation is not shown in the figure). The greater the depth of the second trench gate is, the lower the resistance of a JFET region is, such that the current density of the MOSFET is increased and the parasitic diode capability is improved. The buffer layer 800 may have a thickness of 0.5 µm-3 µm, and a doping concentration of 1 × 10¹⁸ cm⁻³-1 × 10¹⁹ cm⁻³.

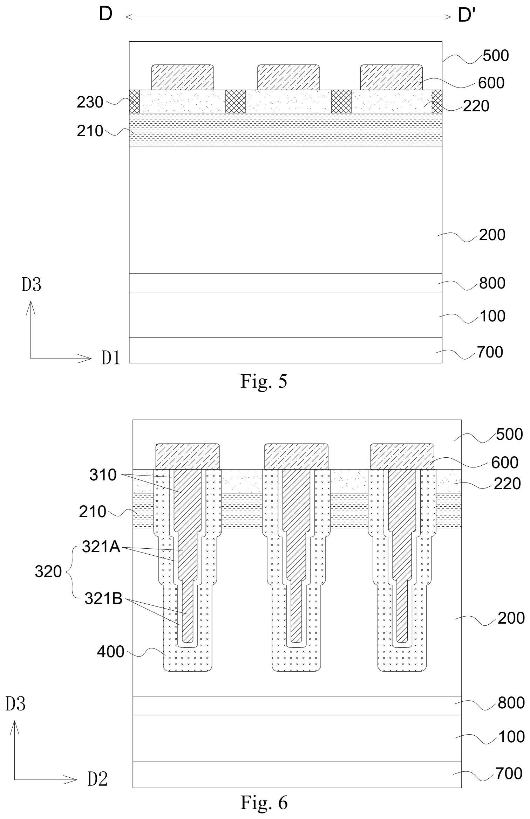

In some embodiments of the present disclosure, individual portions of the second trench gate may have the same width in the third direction D3. Alternatively, in other embodiments of the present disclosure, referring to Figure 6, the second trench gate 320 includes a plurality of trench gate portions that are connected with each other (such as 321A and 321B as shown in the figure), which are sequentially arranged in a direction in which the epitaxial layer 200 faces the substrate 100, and have a width decreasing in sequence. As shown in the figure, the width of the trench gate portion 321B located below is smaller than that of the trench gate portion 321A located above, that is, the second trench gate is composed of multi-level trench gate portions. The second trench gate composed of the plurality of trench gate portions may extend into the buffer layer or may penetrate through the buffer layer and extend into the substrate. The second trench gate is composed of a gate oxide layer disposed on the inner wall and the bottom of the second trench, and a gate electrode layer filled in the middle of the second trench and in contact with the gate oxide layer. Thus, each trench gate portion is also composed of a gate oxide layer and a gate electrode layer, and the gate electrode layers in individual trench gate portions are connected with each other.

In some embodiments of the present disclosure, referring to Figure 2, a thickness d₁ of a portion of the shielding region 400 covering the sidewalls of the first trench gate 310 is consistent with a thickness d₂ of a portion the shielding region 400 wrapping around the sidewalls of the second trench gate 320, and d₁ and d₂ each may be 0.1 µm-1 µm, such that, in one aspect, the electric field stress of the gate oxide is reduced, and in another aspect, a conductive region is allowed to have an appropriate length and the shielding region is prevented from being broken. A thickness d₃ of the shielding region 400 wrapping around the bottom of the second trench gate 320 may be 0.5 µm-2 µm, such that the electric field stress of the gate oxide may be effectively reduced. A length of the shielding region in the first direction may be determined based on the length of the second trench gate and the thickness of the shielding region covering the sidewalls of the second trench gate.

In some embodiments of the present disclosure, the shielding region 400 may have a doping concentration of 1 × 10¹⁶ cm⁻³-1 × 10¹⁹ cm⁻³. The shielding region may reduce the electric field stress of the gate oxide in a three-dimensional direction. When the MOSFET is in a blocking state, the shielding region and the epitaxial layer are completely depleted, and the doping concentration of the epitaxial layer may be increased to 1 × 10¹⁶ cm⁻³-5 × 10¹⁷ cm⁻¹, thereby improving the current density of the MOSFET. The substrate may be an N-type silicon carbide substrate, and the shielding region may be a P-type shielding region.

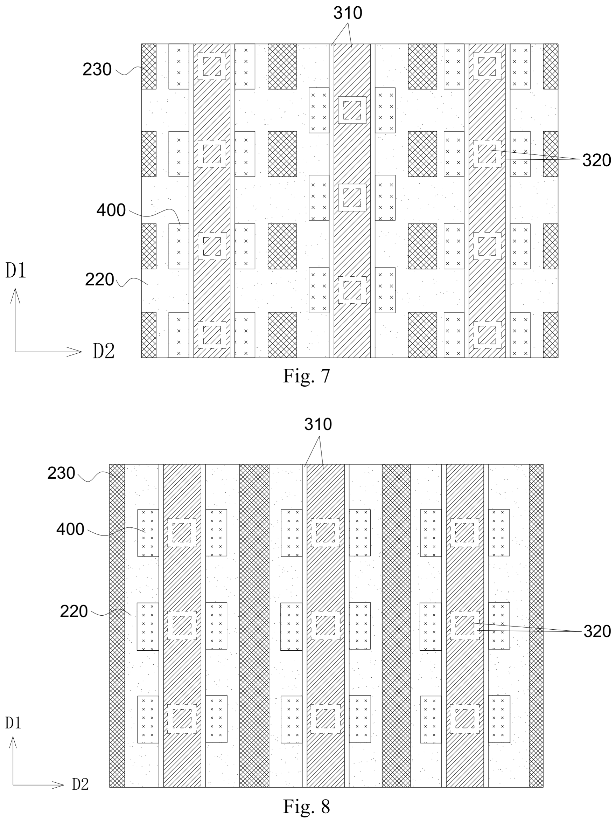

In some embodiments of the present disclosure, referring to Figure 1, the metal oxide semiconductor field-effect transistor includes a plurality of trench gate groups 300. The first trench gates 310 in the plurality of trench gate groups 300 are sequentially arranged along the second direction D2. In the second direction D2, two adjacent second trench gates 320 are arranged in a same row (as shown in Figure 1) or in a staggered row (as shown in Figure 7).

In some embodiments of the present disclosure, referring to Figure 3, N+ regions 220 and P+ regions 230 in the epitaxial layer 200 extend into the epitaxial layer 200 from the surface of the epitaxial layer 200 on a side thereof away from the substrate 100. A top of a P well region 210 in the epitaxial layer 200 is in contact with a bottom of the N+ region 220 and a bottom of the P+ region 230. The first trench gate 310 penetrates through the N+ region 220 and the P well region 210. Referring to Figures 1 and 7, the P+ regions 230 are arranged along at intervals along the first direction D1 and each is located between two adjacent first trench gates 310, and the N+ region 220 is located around the P+ region 230. That is, in the second direction D2, the P+ region 230 may be arranged with the second trench gate 320 in the same row (not shown in the figure), or, the second trench gate 320 may be located between two adjacent rows of P+ regions 230 (as shown in Figure 1), or, a part of the second trench gates 320 are arranged with the P+ region in the same row, and another part of the second trench gates 320 are located between two adjacent rows of P+ regions (as shown in Figure 7). Alternatively, referring to Figure 8, the P+ region 230 extends along the first direction D1 and is located between two adjacent first trench gates 310, and the N+ region 220 is located on two sides of the P+ region 230. Due to the three-dimensional shielding region, the size of MOSFET cell in a two-dimensional direction is reduced, thereby increasing the area proportion of the P+ region and improving the current capability of the parasitic diode. By adjusting the area proportion of the P+ region and N+ region, the current capability of the parasitic diode may be regulated. The P well region may have a junction depth of 0.2 µm-1 µm, and a doping concentration of 1 × 10¹⁷ cm⁻³-1 × 10¹⁸ cm⁻³. The N+ region may have a junction depth of 0.1 µm-0.4 µm, and a doping concentration of 5 × 10¹⁸ cm⁻³-5 × 10²⁰ cm⁻¹. The P+ region may have a junction depth of 0.1 µm-1.5 µm, and a doping concentration of 5 × 10¹⁸ cm⁻³-5 × 10²⁰ cm⁻³.

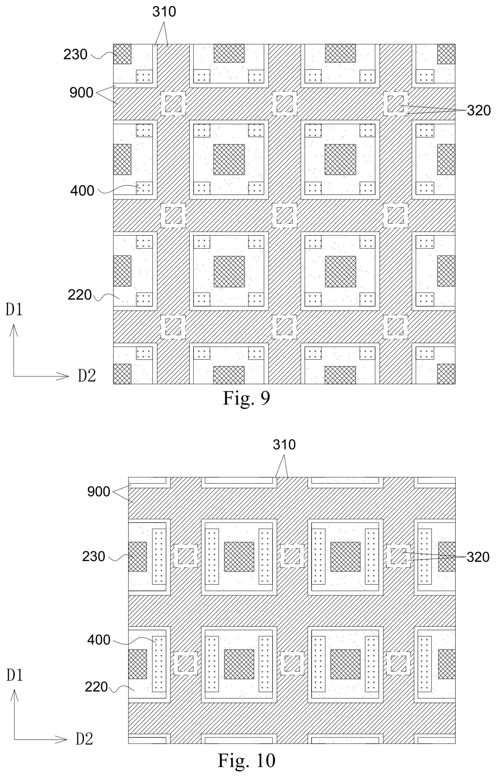

In other embodiments of the present disclosure, referring to Figures 9 and 10, the metal oxide semiconductor field-effect transistor includes a plurality of trench gate groups 300 and a plurality of third trench gates 900. The first trench gates 310 in the plurality of trench gate groups 300 are sequentially arranged along the second direction D2, and the plurality of third trench gates 900 extend along the second direction D2 and are sequentially arranged along the first direction D1. The third trench gate 900 extends into the epitaxial layer 200 from the surface of the epitaxial layer 200 on a side thereof away from the substrate 100 (a cross-sectional view of the third trench gate is not shown in the figure). Thus, the third trench gate 900 intersects with the first trench gate 310, and the orthographic projection of the second trench gate 320 on the substrate may be located within an orthographic projection range of an intersecting region of the first trench gate 310 and the third trench gate 900 on the substrate. Each shielding region further covers the sidewalls of the third trench gate 900 (as shown in Figure 9). Alternatively, the orthographic projection of the second trench gate 320 on the substrate is located between the orthographic projections of two adjacent third trench gates 900 on the substrate, and each shielding region 400 is located between two adjacent third trench gates 900 (as shown in Figure 10). The third trench gates 900 and the first trench gates 310 define multiple cells, which may have a square, hexagonal, octagonal, or circlar shape.

In this embodiment, the N+ region 220 and the P+ region 230 in the epitaxial layer extend into the epitaxial layer from the surface of the epitaxial layer on a side thereof away from the substrate. The top of the P well region 210 in the epitaxial layer is in contact with the bottom of the N+ region 220 and the bottom of the P+ region 230. Both of the first trench gate 310 and the third trench gate 900 penetrate through the N+ region 220 and the P well region 210 (a cross-sectional view of the third trench gate is not shown in the figure). The P+ region 230 is located in a region surrounded by the first trench gate 310 and the third trench gate 900, and the N+ region 220 is located around the P+ region 230 (as shown in Figures 9 and 10).

Referring to Figure 2, the metal oxide semiconductor field-effect transistor further includes an interlayer dielectric layer 600, a source electrode 500, and a drain electrode 700. The interlayer dielectric layer 600 is located on a side of the first trench gate 310 away from the substrate, and the interlayer dielectric layer may have a thickness of 0.3 µm-0.8 µm. The source electrode 500 covers the interlayer dielectric layer 600, the P+ region 230 and the N+ region 220. The interlayer dielectric layer 600 has vias (not shown in the figure) connecting the source electrode 500 and the gate electrode layer 20. The source electrode 500 forms an ohmic contact with the P+ region 230 and the N+ region 220. The source electrode 500 may comprise a nickel layer that forms an ohmic contact with the P+ region 230 and the N+ region 220, and a metal aluminum layer located on a side of the nickel layer away from the substrate. The nickel layer may have a thickness of 500 Å-2500 Å, and the aluminum layer may have a thickness of 1 µm-6 µm. The drain electrode 700 is located on a side of the substrate 100 away from the epitaxial layer 200, and a material of the drain electrode may include Ti, Ni, and Ag. The plurality of shielding regions are connected in parallel to the source electrode.

It should be noted that, for the convenience of showing the positional relationships of the first trench gate, the shielding region, the P+ region, and the N+ region, none of the Figures 1, 7-10 shows the interlayer dielectric layer and the source electrode located above the epitaxial layer.

In another aspect of the present disclosure, a method for manufacturing the metal oxide semiconductor field-effect transistor is proposed. The metal oxide semiconductor field-effect transistor manufactured by this method may be the metal oxide semiconductor field-effect transistor described above. Therefore, the metal oxide semiconductor field-effect transistor manufactured by this method may have the same features and beneficial effects as the metal oxide semiconductor field-effect transistor described above, which will not be repeated here.

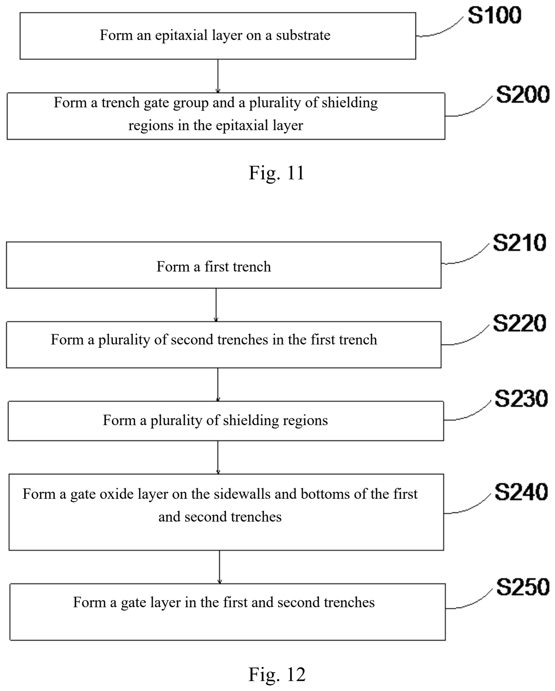

In some embodiments of the present disclosure, referring to Figure 11, the method includes steps S100 and S200.

In step S100: forming an epitaxial layer on a substrate.

In this step, the epitaxial layer is formed on the substrate. The substrate may be an N-type silicon carbide substrate formed by an in-situ doping process, and may have a doping element of nitrogen, a thickness of 80 µm-350 µm, and a doping concentration of 1 × 10¹⁸ cm⁻³-5 × 10¹⁹ cm⁻³.

A formation method of the epitaxial layer is not particularly limited. For example, a homoepitaxial growth process may be used to form the epitaxial layer, which has a doping element of nitrogen, a thickness of 5 µm-120 µm and a doping concentration of 2 × 10¹⁴ cm⁻³-3 × 10¹⁶ cm⁻³.

In this step, a buffer layer may also be formed on the substrate in advance before forming the epitaxial layer. A formation method of the buffer layer is also not particularly limited. For example, an in-situ doping process may be used to form the buffer layer, which has a doping element of nitrogen, a thickness of 0.5 µm-3 µm, and a doping concentration of 1 × 10¹⁸ cm⁻³-1 × 10¹⁹ cm⁻³.

In step S200: Forming a trench gate group and a plurality of shielding regions in the epitaxial layer.

In this step, a trench gate group and a plurality of shielding regions are formed in the epitaxial layer. The trench gate group includes a first trench gate and a plurality of second trench gates. The first trench gate extends into the epitaxial layer from a surface of the epitaxial layer on a side thereof away from the substrate, and the first trench gate extends along a first direction in the plane where the epitaxial layer is located. The plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate. Each shielding region wraps around a bottom and all the sidewalls of the second trench gate, and extends towards a surface of the epitaxial layer on a side thereof away from the substrate to cover sidewalls of the first trench gate, and the plurality of shielding regions are arranged at intervals. Thus, the shielding region is formed as a three-dimensional structure. In a first aspect, the shielding region can reduce the electric field stress of the gate oxide in the trench gate, thereby improving the long-term reliability of the MOSFET. In a second aspect, compared with the current two-dimensional shielding structures, the three-dimensional shielding region of the present disclosure may significantly reduce the size of the MOSFET cell in a two-dimensional direction, thereby improving the current density of the MOSFET. In a third aspect, the shielding region around the second trench gate is completely depleted when the MOSFET is in a blocking state, such that a doping concentration of the epitaxial layer may be significantly increased, and the resistance of a JFET region may be reduced, thereby improving the current density of the MOSFET.

Before forming the trench gate group and the plurality of shielding regions in the epitaxial layer, this step further includes:
forming a P well region in the epitaxial layer, wherein, a specific process for forming the P well region is not particularly limited, for example, the P well region is formed by a high-temperature ion implantation process at 500°C, and has a junction depth of 0.2 µm-1 µm, a doping concentration of 1 × 10¹⁷ cm⁻³-1 × 10¹⁸ cm⁻¹, and a doping element of aluminum, so as to form a channel region;
forming N+ regions in the epitaxial layer, wherein, the N+ region is located on a side of the P well region away from the substrate, and a bottom of the N+ region is in contact with a top of the P well region, a specific process for forming the N+ region is not particularly limited, for example, the N+ region is formed by a high-temperature ion implantation process at 500°C, and has a junction depth of 0.1 µm-0.4 µm, a doping concentration of 5 × 10¹⁸ cm⁻³-5 × 10²¹ cm⁻¹, and a doping element of nitrogen; and
forming P+ regions in the epitaxial layer, wherein, the P+ region is located on the side of the P well region away from the substrate, a bottom of the P+ region is in contact with the top of the P well region, the P+ regions are arranged at intervals in the N+ region in the first direction, or, the P+ region extends along the first direction, and the N+ region is located on two sides of the P+ region, a specific process for forming the P+ region is not particularly limited, for example, the P+ region is formed by a high-temperature ion implantation process at 500°C, and has a junction depth of 0.1 µm-1.5 µm, a doping concentration of 5 × 10¹⁸ cm⁻³-5 × 10²⁰ cm⁻³, and a doping element of aluminum.

In a process of forming the N+ region and the P+ region, a photolithography process may be employed, such that the N+ region and the P+ region may be formed through ion implantation by selectively covering a part of the surface of the epitaxial layer with photoresist.

In this step, referring to Figure 12, a method of forming the trench gate group and the plurality of shielding regions in the epitaxial layer includes steps S210 to S250.

In step S210: forming a first trench.

In this step, the first trench is formed. The first trench extends into the epitaxial layer from the surface of the epitaxial layer on a side thereof away from the substrate, penetrates through the N+ region and P well region, and extends along the first direction. A specific process for forming the first trench is not particularly limited, for example, the first trench is formed in the epitaxial layer by plasma etching. The first trench may have a width of 0.3 µm-2 µm, and a depth of 0.4 µm-2 µm.

By means of this step, a plurality of first trenches extending along the first direction and sequentially arranged along the second direction are formed in the epitaxial layer, in order to subsequently form a plurality of trench gate groups. The second direction is a direction intersecting with the first direction on the plane where the epitaxial layer is located. Specifically, the second direction may be perpendicular to the first direction.

This step may also includes forming a plurality of third trenches extending along the second direction and sequentially arranged along the first direction while forming the first trenches, in order to subsequently form third trench gates. The third trench gates and the first trench gates defines multiple cells. A width and depth of the third trench may be consistent with a width and depth of the first trench, respectively. A specific process for forming the third trench is not particularly limited, for example, the third trench is formed in the epitaxial layer by plasma etching.

In step S220: forming a plurality of second trenches in the first trench.

In this step, the plurality of second trenches are formed in the first trench, and the plurality of second trenches are arranged at intervals along the first direction. A width of the second trench may be equal to or less than a width of the first trench, and a depth of the second trench is not particularly limited. For example, the second trench may extend into the substrate, or, when a buffer layer is disposed between the substrate and the epitaxial layer, the second trench may extend into the buffer layer or or may penetrate through the buffer layer and extend into the substrate. This facilitates further reduction of the resistance of the JFET region, and improvement of the current density of MOSFET.

Individual portions of the second trench may have the same width in the third direction D3 (i.e. a direction of stacking the substrate and the epitaxial layer). Alternatively, the second trench may includes a plurality of trench portions that are connected with each other, are sequentially connected in a direction in which the epitaxial layer faces the substrate, and have a width decreasing in sequence, that is, a multi-level trench is formed. The second trench composed of the plurality of trench portions may extend into the buffer layer or may penetrate through the buffer layer and extend into the substrate.

A specific process for forming the second trench is not particularly limited, for example, the plurality of second trenches are formed in the first trench by plasma etching.

In other embodiments of the present disclosure, a plurality of third trenches are formed in the epitaxial layer. At this time, the second trench may be located below an intersection region of the first trench and the third trench, or, the second trench may be located between two adjacent third trenches.

In step S230: forming a plurality of shielding regions.

In this step, the plurality of shielding regions are formed. Each shielding region wraps around the bottom and all sidewalls of the second trench, and extends towards the surface of the epitaxial layer on a side thereof away from the substrate, to cover sidewalls of the first trench. Since the second trenches are arranged at intervals along the first direction, the shielding region may cover the sidewalls of the second trench along the second direction and the sidewalls thereof along the first direction, thereby forming a three-dimensional shielding region.

A specific process for forming the shielding region is not particularly limited. For example, the shielding region is formed by high-temperature ion implantation process at 500°C, and has a doping concentration of 1 × 10¹⁶ cm⁻³-1 × 10¹⁹ cm⁻³ and a doping element of aluminum. The electric field stress of the gate oxide layer may be reduced in a three-dimensional direction. When the MOSFET is in a blocked state, the shielding region and the epitaxial layer are completely depleted, and the doping concentration of the epitaxial layer may be increased to 1 × 10¹⁶ cm⁻¹-5 × 10¹⁷ cm⁻³, thereby improving the current density of the MOSFET.

Since each shielding region wraps around the bottom and all sidewalls of the second trench, and extends towards the surface of the epitaxial layer on a side thereof away from the substrate, to cover the sidewalls of the first trench, a region where ion implantation is performed on the epitaxial layer covers the second trench, and a width of this region is greater than that of the first trench.

In this step, a high-temperature annealing at 1600°C-1900°C may be performed to activate the doping impurities in the P well region, the P+ region, the N+ region, and the shielding region, and repair the lattices thereof.

In other embodiments of the present disclosure, a plurality of third trenches are formed in the epitaxial layer, and the second trench may be located below an intersection region of the first trench and the third trench, at this time, each shielding region further covers the sidewalls of the third trench; or, the second trench is located between two adjacent three trenches, at this time, each shielding region is located between two adjacent third trenches.

In step S240: forming a gate oxide layer on the sidewalls and bottoms of the first and second trenches.

In this step, a gate oxide layer is formed on the sidewalsl and bottoms of the first and second trenches. A specific process for forming the gate oxide layer is not particularly limited, for example, a 300 Å-1000 Å thick gate oxide layer is formed in the first and second trenches by using a thermal oxidation method.

This step may also comprise forming a gate oxide layer on the sidewalls and bottom of the third trench, in order to subsequently form the third trench gate.

In step S250: forming a gate electrode layer in the first and second trenches.

In this step, a gate electrode layer is formed in the first and second trenches, and the gate electrode layer is in contact with the gate oxide layer to form the first and second trench gates, thereby forming the trench gate group. A specific process for forming the gate electrode layer is not particularly limited, for example, a polycrystalline silicon gate electrode is formed by depositing polycrystalline silicon on the gate oxide layer using low-pressure chemical vapor deposition.

This step may also comprise forming a gate electrode layer in the third trench to form the third trench gate.

The method also includes: depositing a 0.3 µm-0.8 µm thick oxide layer on the polycrystalline silicon gate electrode by using plasma chemical vapor deposition, to form an interlayer dielectric layer, and forming gate electrode-source electrode contact holes in the interlayer dielectric layer via graphic processing;
sputtering a 500 Å-2500 Å thick nickel layer on the interlayer dielectric layer and epitaxial layer, performing annealing at 900°C-1100°C to allow the nickel layer to form ohmic contact with the P+ region and the N+ region, and depositing a 1 µm-6 µm thick aluminum layer on the nickel layer, to form a source electrode; and
sequentially sputtering metal Ti, Ni, and Ag on a side of the substrate away from the epitaxial layer, to form a drain electrode.

In the description of the present disclosure, the terms "first" and "second" are only used for the purpose of description, but should not be understood as indicating or implying relative importance or implying the number of technical features indicated. Thus, the features defined by "first" and "second" may explicitly or implicitly includes one or more of these features. In the description of the present disclosure, "a plurality of" means two or more, unless otherwise specifically defined.

In the description of the specification, the description with reference to the terms "an embodiment", "some embodiments", "an example", "a specific example", or "some examples" means that the specific features, structures, materials, or characteristics described in conjunction with the embodiment or the example are included in at least one embodiment or example of the description. In the specification, the schematic expressions of the above terms are not necessarily directed at the same embodiment or example. Moreover, the specific features, structures, materials, or characteristics described may be combined in any one or more embodiments or examples in an appropriate manner. In addition, those skilled in the art may incorporate and combine the different embodiments or examples described in this specification, as well as the features of said different embodiments or examples, without conflicting with each other.

Although the embodiments of the present disclosure have been shown and described above, it may be understood that, the above embodiments are exemplary and should not be construed as limiting the present disclosure. Those skilled in the art may make changes, modifications, substitutions, and variations to the above embodiments within the scope of the present disclosure.

### List of Reference numbers

100: Substrate; 200: Epitaxial layer; 210: P well region; 220: N+ region; 230: P+ region; 300: Trench gate group; 310: First trench gate; 320: Second trench gate; 321A/321B: Trench gate portion; 10: Gate oxide layer; 20: Gate electrode layer; 400: Shielding region; 500: Source electrode; 600: Interlayer dielectric layer; 700: Drain electrode; 800: Buffer layer; 900: Third trench gate; D1: First direction; D2: Second direction; D3: Third direction.

## Claims

1. A metal oxide semiconductor field-effect transistor, **characterized in that** comprising:
a substrate;
an epitaxial layer, disposed on the substrate;
a trench gate group, comprising a first trench gate and a plurality of second trench gates, wherein the first trench gate extends into the epitaxial layer from a surface of the epitaxial layer on a side thereof away from the substrate, and the first trench gate extends along a first direction in a plane where the epitaxial layer is located, the plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate; and
a plurality of shielding regions, each of which wraps around a bottom and all the sidewalls of the second trench gate, and extends towards a surface of the epitaxial layer on a side thereof away from the substrate to cover sidewalls of the first trench gate, and the plurality of shielding regions are arranged at intervals.

2. The metal oxide semiconductor field-effect transistor of claim 1, **characterized in that** the second trench gate extends into the substrate in a direction of stacking the substrate and the epitaxial layer; or,
a buffer layer is disposed between the substrate and the epitaxial layer, and the second trench gate extends into the buffer layer or into the substrate in the direction of stacking the substrate and the epitaxial layer.

3. The metal oxide semiconductor field-effect transistor of claim 1 or 2, **characterized in that** the second trench gate comprises a plurality of trench gate portions that are connected with each other, and the plurality of trench gate portions are sequentially arranged in a direction in which the epitaxial layer faces the substrate, with their widths decreasing in sequence.

4. The metal oxide semiconductor field-effect transistor of claim 1, **characterized in that** a thickness of a portion of the shielding region covering the sidewalls of the first trench gate is consistent with a thickness of a portion of the shielding region wrapping around the sidewalls of the second trench gate, and the thickness is 0.1 µm-1 µm, and a thickness of a portion of the shielding region wrapping around the bottom of the second trench gate is 0.5 µm-2 µm.

5. The metal oxide semiconductor field-effect transistor of claim 1, **characterized in that** the shielding region has a doping concentration of 1 × 10¹⁶ cm⁻³-1 × 10¹⁹ cm⁻³.

6. The metal oxide semiconductor field-effect transistor of claim 1, **characterized in that** comprising a plurality of trench gate groups, wherein first trench gates in the plurality of trench gate groups are sequentially arranged along a second direction in the plane where the epitaxial layer is located, the second direction intersects with the first direction, and two adjacent second trench gates are arranged in a same row or in a staggered row in the second direction.

7. The metal oxide semiconductor field-effect transistor of claim 1, **characterized in that** comprising a plurality of trench gate groups, wherein first trench gates in the plurality of trench gate groups are sequentially arranged along a second direction in the plane where the epitaxial layer is located, and the second direction intersects with the first direction,
N+ regions and P+ regions in the epitaxial layer extend into the epitaxial layer from the surface of the epitaxial layer on a side thereof away from the substrate, a top of a P well region in the epitaxial layer is in contact with a bottom of the N+ region and a bottom of the P+ region, and the first trench gate penetrates through the N+ region and the P well region,
the P+ regions are arranged at intervals along the first direction and each is located between two adjacent first trench gates, and the N+ region is located around the P+ region, or, the P+ regions extend along the first direction and each is located between two adjacent first trench gates, and the N+ region is located on two sides of the P+ region.

8. The metal oxide semiconductor field-effect transistor of claim 1, **characterized in that** comprising:
a plurality of trench gate groups, wherein first trench gates in the plurality of trench gate groups are sequentially arranged along a second direction in the plane where the epitaxial layer is located, and the second direction intersects with the first direction; and
a plurality of third trench gates extending along the second direction and sequentially arranged along the first direction, the third trench gates each extending into the epitaxial layer from the surface of the epitaxial layer on a side thereof away from the substrate,
the orthographic projection of the second trench gate on the substrate is located within an orthographic projection range of an intersection region of the first trench gate and the third trench gate on the substrate, and each shielding region further covers sidewalls of the third trench gate,
or, the orthographic projection of the second trench gate on the substrate is located between the orthographic projections of two adjacent third trench gates on the substrate, and each shielding region is located between the two adjacent third trench gates.

9. The metal oxide semiconductor field-effect transistor of claim 8, **characterized in that** N+ regions and P+ regions in the epitaxial layer extend into the epitaxial layer from a surface of the epitaxial layer on a side thereof away from the substrate, a top of a P well region in the epitaxial layer is in contact with a bottom of the N+ region and a bottom of the P+ region, both of the first trench gate and the third trench gate penetrate the N+ region and the P well region, the P+ region is located in a region surrounded by the first trench gate and the third trench gate, and the N+ region is located around the P+ region.

10. The metal oxide semiconductor field-effect transistor of claim 8, **characterized in that** the third trench gates and the first trench gates define multiple cells, and the cell has a square, hexagonal, octagonal, or circular shape.

11. A method for manufacturing a metal oxide semiconductor field-effect transistor, **characterized in that** comprising:
forming an epitaxial layer on a substrate; and
forming a trench gate group and a plurality of shielding regions in the epitaxial layer, wherein the trench gate group comprises a first trench gate and a plurality of second trench gates, the first trench gate extends into the epitaxial layer from a surface of the epitaxial layer on a side thereof away from the substrate, and the first trench gate extends along a first direction in a plane where the epitaxial layer is located, the plurality of second trench gates are arranged at intervals along the first direction, an orthographic projection of the second trench gate on the substrate is located within an orthographic projection range of the first trench gate on the substrate, a top of the second trench gate is in contact with a bottom of the first trench gate, and a gate electrode layer in the second trench gate is connected with a gate electrode layer in the first trench gate, each shielding region wraps around a bottom and all the sidewalls of the second trench gate, and extends towards a surface of the epitaxial layer on a side thereof away from the substrate to cover sidewalls of the first trench gate, and the plurality of shielding regions are arranged at intervals.

12. The method of claim 11, **characterized in that** forming a trench gate group and a plurality of shielding regions in the epitaxial layer comprises:
forming a first trench, wherein the first trench extends into the epitaxial layer from a surface of the epitaxial layer on the side away from the substrate, and the first trench extends along the first direction;
forming a plurality of second trenches in the first trench, wherein the plurality of second trenches are arranged at intervals along the first direction;
forming a plurality of shielding regions, wherein each shielding region wraps around the bottom and all sidewalls of the second trench, and extends towards the surface of the epitaxial layer on a side thereof away from the substrate to cover the sidewalls of the first trench;
forming a gate oxide layer on the sidewalls and the bottoms of the first trench and the second trench; and
forming a gate electrode layer in the first trench and the second trench, wherein the gate electrode layer to is in contact with the gate oxide layer to form the first trench gate and the second trench gate, so as to form the trench gate group.
